(19) Europäisches Patentamt
European Patent Office
Office européen des brevets

(11) **EP 2 722 903 B1**

(12) **EUROPEAN PATENT SPECIFICATION**

(45) Date of publication and mention
of the grant of the patent:
**06.01.2016 Bulletin 2016/01**

(51) Int Cl.:
***H01L 49/00*** *(2006.01)*

(21) Application number: **12800072.6**

(22) Date of filing: **11.05.2012**

(86) International application number:
**PCT/JP2012/062173**

(87) International publication number:
**WO 2012/172898 (20.12.2012 Gazette 2012/51)**

(54) **STRONGLY CORRELATED OXIDE FIELD EFFECT ELEMENT**

FELDEFFEKTBAUELEMENT MIT STARK KORRELIERTEM OXID

ÉLÉMENT À EFFET DE CHAMP À OXYDE FORTEMENT CORRÉLÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.06.2011 JP 2011134447**

(43) Date of publication of application:
**23.04.2014 Bulletin 2014/17**

(73) Proprietor: **Fuji Electric Co., Ltd.
Kawasaki-shi 210-9530 (JP)**

(72) Inventor: **OGIMOTO, Yasushi
Kawasaki-shi 210-9530 (JP)**

(74) Representative: **Appelt, Christian W.
Boehmert & Boehmert
Anwaltspartnerschaft mbB
Patentanwälte Rechtsanwälte
Pettenkoferstrasse 20-22
80336 München (DE)**

(56) References cited:
**WO-A1-2004/023563      JP-A- 2003 101 018
JP-A- 2010 166 039      US-B1- 6 426 536
US-B2- 6 890 766**

- WU T ET AL: "Electroresistance and Electronic
Phase Separation in Mixed-Valent Manganites",
PHYSICAL REVIEW LETTERS, vol. 86, no. 26, 25
June 2001 (2001-06-25) , pages 5998-6001,
XP002347047, ISSN: 0031-9007, DOI:
10.1103/PHYSREVLETT.86.5998
- ZHAO T ET AL: "Colossal magnetoresistive
manganite-based ferroelectric field-effect
transistor on Si", APPLIED PHYSICS LETTERS,
vol. 84, no. 5, 2 February 2004 (2004-02-02), pages
750-752, XP012061985, ISSN: 0003-6951, DOI:
10.1063/1.1644321
- YASUSHI OGIMOTO: 'Interface-mediated phase
control in ultrathin double-layer structures of
perovskite manganites' ABSTRACTS OF THE
MEETING OF THE PHYSICAL SOCIETY OF
JAPAN vol. 65, 3, no. 1, 01 March 2010, page 663,
XP008171591

**Description**

TECHNICAL FIELD

The present invention relates to a strongly correlated oxide field effect element. More specifically, the present invention relates to a strongly correlated oxide field effect element demonstrating a switching function induced by electrical means.

BACKGROUND ART

There are growing concerns that the scaling law which has been a guideline for improving performance of semiconductor devices is gradually reaching the limits. At the same time, the development of materials that will enable new operational principles necessary to get through a crisis following the transistor limit has been advanced. For example, the developments aimed at high-density nonvolatile memory devices capable of operating at a high speed equal to that of dynamic random access memory (DRAM) have been advanced in the field of spintronics incorporating the degree of freedom of electron spins.

Meanwhile, the research of materials having a strongly correlated electron system to which the band theory underpinning the foundations of semiconductor device design cannot be applied has been also been advanced. The result of such advances is the appearance of substances demonstrating colossal and fast changes in physical properties originating in phase transitions in the electron system. In strongly correlated electron system materials, a large number of electronic phases of various orders formed by spins, charges, and orbitals appear due to the contribution of the degrees of freedom of not only spins, but also electron orbitals to the state of electronic phase. Perovskite manganese oxide (perovskite manganite) is a representative example of strongly correlated electron system materials, and a charge-ordered phase in which 3d electrons of manganese (Mn) are ordered by a first order phase transition and an orbital-ordered phase in which electron orbitals are ordered are known to appear in the electron system thereof.

In the charge-ordered phase or orbital ordered phase, an electric resistance increases due to localization of carriers, and the electron phase becomes an insulator phase. Magnetic properties of this electron phase are those of an antiferromagnetic phase due to the double exchange interaction and the superexchange interaction. In many cases, the electronic state of the charge-ordered phase and orbital-ordered phase should be considered as semiconductive. In the charge-ordered phase and orbital-ordered phase, although the carriers are localized, the electric resistance is lower than that of the so-called band insulators. Thus, according to the established practice, the electron phase of the charge-ordered phase and orbital-ordered phase is represented as an insulator phase. Conversely, when the electric resistance is low and metallic behavior is demonstrated, spins are arranged and therefore the electron phase is a ferromagnetic phase. There are various definitions of a metallic phase, but in the present application, "a phase with a positive sign of temperature derivative of resistivity" is represented as a metallic phase. According to such representation, the aforementioned insulator phase can be redefined as "a phase with a negative sign of temperature derivative of resistivity".

It has been indicated that various switching effects can be observed in single-crystal bulk materials of substances that can include some of electron phases in which both the charge order and the orbital order are realized (charge- and orbital-ordered phase) in addition to the charge-ordered phase and orbital-ordered phase (Patent Document 1: Japanese Patent Application Publication No. H8-133894; Patent Document 2: Japanese Patent Application Publication No. H10-255481; Patent Document 3: Japanese Patent Application Publication No. H10-261291). Those switching effects are demonstrated in response to a stimulation action, for example, temperature changes to both sides of the transition point, application of magnetic or electric field, and light irradiation. Those switching effects are typically observed as colossal changes in electric resistance and phase transition between the antiferromagnetic phase and ferromagnetic phase. For example, resistance changes of some order of magnitude that are caused by magnetic field application are well known as a colossal magnetoresistance effect.

From the very beginning, the attempts have been made to study field effect elements using thin films of such strongly correlated electron system materials as channel layers. For example, it is reported that when $La_{0.7}Ca_{0.3}MnO_3$ film is used as a channel layer and a ferroelectric $PbZr_{0.2}Ti_{0.8}O_3$ film is fabricated as a gate insulating layer thereupon, nonvolatile resistance changes are caused in the channel layer by the remnant polarization of the ferroelectric $PbZr_{0.2}Ti_{0.8}O_3$ film (Non-Patent Document 1). In the Non-Patent Document 1, the resistance of the channel layer is reported to be decreased by the application of a positive voltage and increased by the application of a negative voltage. Further, a pn junction is reported that uses the availability of first order transition in a single crystal thin film on a substrate with (110) orientation (Patent Document 4), $Nd_{0.5}Sr_{0.5}MnO_3$ film, which is a strongly correlated oxide film demonstrating a metal-insulator transition, as a p layer, and a Nb-doped $SrTiO_3$ (110) substrate as an n layer (Non-Patent Document 2). Further, research of a 3-terminal device using a $NdNiO_3$ film demonstrating a metal-insulator transition has recently been also reported (Non-Patent Document 3).

Patent Document 1: Japanese Patent Application Publication No. H8-133894

Patent Document 2: Japanese Patent Application Publication No. H10-255481

Patent Document 3: Japanese Patent Application Publication No. H10-261291

Patent Document 4: Japanese Patent Application Publication No. 2005-213078

Non-Patent Document 1: S. Mathews et al., "Ferroelectric Field Effect Transistor Based on Epitaxial Perovskite Heterostructures", Science vol. 276, 238 (1997)

Non-Patent Document 2: J. Matsuno et al., "Magnetic field tuning of interface electronic properties in manganitetitanate junctions", Applied Physics Letters vol. 92, 122104

(2008) Non-Patent Document 3: S. Asanuma et al., "Tuning of the metal-insulator transition in electrolyte-gated NdNiO3", Applied Physics Letters vol. 97, 142110 (2010)

Field effect transistors with channel formed by a single insulator-metal transition layer are also known from EP 1 548 843 A1, US 6 890 766 B2, and US 6 426 536 B1.

DISCLOSURE OF THE INVENTION

However, according to Non-Patent Document 1, the amount of electric resistance changes that appears in a range of applied voltage of $\pm 10$ V stays at about three times when taken as a ratio. In the pn junction disclosed in Non-Patent Document 2, colossal changes in capacitance or current density such that can be expected in the light of resistance changes of five or more orders of magnitude demonstrated in a metal-insulator transition in the $Nd_{0.5}Sr_{0.5}MnO_3$ film have also not been observed. In addition, according to Non-Patent Document 3, in a sample with a thickness of channel layer of 5 nm, the temperature of metal-insulator transition is decreased by about 40 K by the application of a gate voltage of -2.5 V, but the transition to a perfect metallic phase caused by the gate voltage is not realized. As shown in those reports, the problem associated with field effect elements using a strongly correlated oxide as a channel layer is that colossal resistance changes (switching) such that were initially expected have not been attained.

The present invention has been created to resolve the above-described problems. The present invention makes a contribution to the realization of a strongly correlated oxide field effect element that can demonstrate a switching function induced by electrical means.

A close examination of the abovementioned problem conducted by the inventor of the present application demonstrates that the aforementioned limitations are due to using a channel layer constituted by a single thin film of a strongly correlated oxide, thereby suggesting a novel approach to the resolution of the problem.

First, the inventor of the present application carefully investigated the reason why the changes in resistance have been insufficient in the previous attempts of using a strongly correlated oxide in a field effect element. This reason has been supposed to be associated with the following mechanism.

The operation principle of a strongly correlated oxide field effect element is that a phase transition is induced by doping carriers into a channel layer by an electric field, and this phase transition is used as a resistance ratio. Thus, changes in resistance cannot be obtained or only slight changes are obtained unless an amount of carriers necessary to induce the phase transition can be doped into the channel layer. In this case, the amount of carriers inside the channel layer that is necessary to induce the phase transition is stipulated as a carrier density. Therefore, it can be said that the phase transition can be facilitated by reducing the thickness of the channel layer and increasing the carrier density.

However, the inventor of the present application noticed that in a strongly correlated oxide field effect element, a phenomenon intrinsic to strongly correlated oxides becomes an impediment. This phenomenon has been found to be associated with a dimensionality relating to a spatial spread of conductive carriers.

In order to stabilize the metallic phase and realize a metal-insulator transition in a strongly correlated oxide film, it is necessary that the thin film be fabricated to a certain thickness. Where the strongly correlated oxide film is too thin, a stable metallic phase is not realized and a metal-insulator transition is also not realized. Thus, a metallic phase is realized and a metal-insulator transition is realized only in a strongly correlated oxide film formed to a thickness greater than a critical value relating to the thickness (referred to hereinbelow as "critical thickness"). In this sense, the critical thickness can be said to be a lower limit value of film thickness necessary for the stable presence of the above-mentioned metallic phase and the realization of the metal-insulator transition. Due to this phenomenon intrinsic to strongly correlated oxides, even when the channel layer thickness is reduced with the object of increasing the carrier density, as mentioned hereinabove, the metallic phase or the metal-insulator transition disappears. The inventor of the present application have concluded that this is the reason why the switching characteristic such that can be expected in thin films of strongly correlated oxides such as Mn oxide and Ni oxide cannot be realized. In particular, the critical thickness of thin films of strongly correlated oxides such as Mn oxide and Ni oxide is larger than the thickness of the channel layer required to realize the carrier density that induces the phase transition. Because of such a contradiction, even if a strongly correlated oxide film demonstrates sufficient switching at a sufficient film thickness, this film cannot be used as is for a field effect element.

It goes without saying, that the amount of carriers should increase with the increase in the gate voltage, in the same manner as in a typical field effect element. In spite of this fact, the preceding research yielded no satisfactory results, which apparently proves that either a gate insulating layer leaks or the anticipated carrier doping cannot be realized despite the application of a voltage that can be applied up to a level close to that causing the insulation breakdown.

Accordingly, in order to avoid such contradiction, the inventor of the present application focused the inventor's attention on the properties inherent to thin films of strongly correlated oxides and decided to adopt an unconventional approach. This approach uses a phenomenon in which changes in the dimensionality of conduction carriers are actively modified, thereby changing the electric resistance.

Thus, an aspect of the present invention resides in a strongly correlated oxide field effect element comprising a channel layer including a strongly correlated oxide film, a gate electrode, a gate insulating layer formed in contact with at least part of a surface or an interface of the channel layer and sandwiched by the channel layer and the gate electrode, and a source electrode and a drain electrode formed in contact with at least part of the channel layer, wherein the channel layer includes an insulator-metal transition layer of a strongly correlated oxide and a metallic state layer of a strongly correlated oxide that are stacked on each other, and a thickness $t$ of the channel layer, a thickness $t1$ of the insulator-metal transition layer, and a thickness $t2$ of the metallic state layer satisfy the following relationship with critical thicknesses $t1c$ and $t2c$ for metallic phases of the insulator-metal transition layer and the metallic state layer: $t = t1 + t2 \geq t1c > t2c$, where $t1 < t1c$ and $t2 < t2c$.

The reasons why a strongly correlated oxide field effect element with good characteristics can be realized in accordance with the abovementioned aspect of the present invention are explained below. Let us consider a channel layer including two layers, namely an insulator-metal transition layer of a strongly correlated oxide that has a thickness $t1$ less than the critical thickness $t1c$ thereof and a metallic state layer of a strongly correlated oxide that has a thickness $t2$ less than the critical thickness $t2c$ thereof. Since either of the insulator-metal transition layer and metallic state layer is thinner that the respective critical thickness $t1c$ and $t2c$ in an independent layer, the metal-insulator transition or metallic phase disappears. However, the inventor of the present application has noticed that the mechanism of this disappearance is due to the small layer thickness and two-dimensional nature of the electron state. Here, it is determined that the thickness $t$ of the entire channel layer including the aforementioned two layers should satisfy the relationship: $t = t1 + t2 \geq t1c > t2c$. In this case, when the insulator-metal transition layer demonstrates a metallic phase, the electron state becomes three-dimensional in the entire channel layer. Therefore, the channel layer as a whole is maintained in the metal-insulator transition or metallic phase. Let us now consider the case in which the insulator-metal transition layer becomes an insulating phase due to a metal-insulator transition. In this case, the carriers located inside the metallic state layer disposed in contact with the insulator-metal transition layer sense only the thickness $t2$ of the metallic state layer of the strongly correlated oxide, rather than the thickness $t$ of the entire channel layer since the insulator-metal transition layer is the insulating phase. Since the thickness $t2$ of the metallic state layer is less than the critical thickness $t2c$ of the metallic phase, the metallic phase of the metallic state layer disappears, thereby increasing the resistance value of the entire channel layer. Thus, the resistance of the entire channel layer is determined by the metal-insulator transition of the insulator-metal transition layer. Therefore, where the insulator-metal transition layer is a metallic phase, the channel layer is a metallic phase with a low resistance value, and where the insulator-metal transition layer is an insulating phase, the channel layer is an insulating phase with a high resistance value. The configuration is known, as shown on the basis of the exemplary embodiments, in which the critical thickness $t1c$ of the insulator-metal transition layer of a strongly correlated oxide is, for example, about 5 nm and the critical thickness $t2c$ of the metallic state layer of a strongly correlated oxide is less than that, but this configuration, not limiting. For example, where the thickness $t1$ of the insulator-metal transition layer is taken as 3 nm and the thickness $t2$ of the metallic state layer of a strongly correlated oxide is taken as 3 nm, the thickness $t$ of the channel layer becomes 6 nm. As described with reference to the related art, the channel layer with a thickness of 5 nm is too thick and field effect-induced switching cannot be obtained. However, where the abovementioned configuration is used, the thickness $t1$ of the insulator-metal transition layer of a strongly correlated oxide in the effective channel layer that should be doped is about 3 nm and therefore the carrier density sufficient for inducing a phase transition can be doped into the $t1$ of the insulator-metal transition layer and colossal resistance changes can be obtained. This is why sufficient resistance changes are realized in the abovementioned aspect.

As follows from the reasons described herein, the critical thicknesses $t1c$ and $t2c$ for respective metallic phases of the insulator-metal transition layer and metallic state layer are not necessarily determined in the same manner for both layers. For example, the critical thickness $t1c$ of the insulator-metal transition layer is determined as a minimum thickness at which an insulator-metal transition occurs in the insulator-metal transition layer, whereas the critical thickness $t2c$ of the metallic state layer is determined as a minimum thickness at which the metallic phase appears. The names of the insulator-metal transition layer, metallic state layer, and other layers referred to in the present application will be explained below. The insulator-metal transition layer of a strongly correlated oxide, as referred to herein, means a layer of a strongly correlated oxide in which an insulator-metal transition can be induced, in the sense of being the layer of a material in which an insulator-metal transition can be induced if this layer is fabricated as a single layer having a thickness equal to or greater than the critical thickness t1c. As for the insulator-metal transition layer with a thickness less than the critical thickness t1c, which is included in the channel layer of each aspect of the present invention, it cannot be said that this film does not correspond to the insulator-metal transition layer of each aspect of the present invention because the insulator-metal transition is not induced when the phase thereof is formed independently with the film thickness thereof. Likewise, the metallic state layer of a strongly correlated oxide is a layer formed by a strongly correlated oxide in a metallic state, in the sense of being the layer of a material in which the metallic state can be assumed if this layer is fabricated as a single layer having a thickness equal to or greater than the critical thickness t2c. As for the metallic state layer fabricated with a thickness less than the critical thickness t2c, which is included in the channel layer of each aspect of the present invention, it cannot be said that this film does not correspond to the metallic state layer of each aspect of the present invention because the metallic phase is not formed and another phase, for example, an insulator phase is formed when this layer is formed independently with the film thickness thereof. The same is true for the determination as to whether or not any layer or film corresponds to the insulator-metal transition layer or metallic state layer of each aspect of the present invention.

In the above-described aspect of the present invention, it is preferred that the insulator-metal transition layer be sandwiched between the metallic state layer and the gate insulating layer.

In the present configuration, carrier doping from the gate electrode acts more effectively on the insulator-metal transition layer, and large changes in resistance value are realized.

The present invention also provides the strongly correlated oxide field effect element according to the above-described aspect that further includes a substrate, wherein the channel layer, the gate insulating layer, and the gate electrode are formed on the substrate in this order. The present invention also provides the strongly correlated oxide field effect element according to the above-described aspect that further includes a substrate, wherein the gate electrode, the gate insulating layer, and the channel layer are formed on the substrate in this order.

With the present configurations, the so-called top-gate field effect element and bottom-gate field effect element can be provided.

The present invention also provides the strongly correlated oxide field effect element according to the above-described aspect, wherein a resistance between a source and a drain is decreased by voltage application via the gate electrode, regardless of polarity of the voltage.

With the present configuration, strongly correlated oxide field effect element that is operated at both polarities is provided. The resultant advantage is that the polarity of voltage applied to the three-terminal element can be freely selected. For example, the channel layer of the strongly correlated oxide field effect element is of a p type, but the polarity of voltage applied to the gate can be selected regardless of whether the carriers of the channel layer are electrons or holes.

The present invention also provides the strongly correlated oxide field effect element according to the above-described aspect, wherein the insulator-metal transition layer and the metallic state layer are made of a perovskite manganite.

With the present configuration, colossal resistance changes caused by a phase transition between a charge- and orbital-ordered insulating phase and a metallic phase in the insulator-metal transition layer of a strongly correlated oxide can be used.

In addition, the present invention also provides the strongly correlated oxide field effect element according to the above-described aspect, wherein the insulator-metal transition layer and the metallic state layer are made of a perovskite manganite, the substrate is made of $(LaAlO_3)_{0.3}(SrAl_{0.5}Ta_{0.5}O_3)_{0.7}$, and the insulator-metal transition layer is made of $(Pr, Sr)MnO_3$.

With the present configuration, colossal and discrete resistance changes caused by a phase transition between a charge- and orbital-ordered insulating phase and a metallic phase in the insulator-metal transition layer of a strongly correlated oxide can be used. Further, "$(Pr, Sr)MnO_3$" can be also represented for example as $Pr_{1-x}Sr_xMnO_3$ (x is from 0 to 1).

In addition, the present invention also provides the strongly correlated oxide field effect element according to the above-described aspect, wherein the insulator-metal transition layer and the metallic state layer are made of a perovskite manganite; the substrate is made of $SrTiO_3$, and the insulator-metal transition layer is made of $(Nd, Sr)MnO_3$.

With the present configuration, colossal and continuous resistance changes caused by a phase transition between a charge- and orbital-ordered insulating phase and a metallic phase in the insulator-metal transition layer of a strongly correlated oxide can be used. Further, "$(Nd, Sr)MnO_3$" can be also represented for example as $Nd_{1-y}Sr_yMnO_3$ (y is from 0 to 1).

The present invention also provides the strongly correlated oxide field effect element according to the above-described aspect in which the aforementioned insulator-metal transition layer and the metallic state layer are a perovskite manganite, wherein the insulator-metal transition layer and the metallic state layer are made of a perovskite manganite, and the substrate has a (110) orientation or a (210) orientation.

With the present configuration, colossal resistance changes caused by a phase transition between a charge- and orbital-ordered insulating phase and a metallic phase can be used by using a single crystal film.

According to any aspect of the present invention, the thickness of the channel layer can be equivalently reduced, while maintaining the metal-insulator transition function, and therefore a strongly correlated oxide field effect element demonstrating a phase transition and a switching function induced by a field effect is realized.

BRIEF DESCRIPTION OF THE DRAWINGS

FIG. 1 is a schematic cross-sectional view of a strongly correlated oxide field effect element of a top-gate structure in an embodiment of the present invention.

FIG. 2 is a schematic cross-sectional view of a strongly correlated oxide field effect element of a bottom-gate structure in an embodiment of the present invention.

FIG. 3 shows graphs of temperature and magnetic field dependence of resistivity of a $Nd_{0.5}Sr_{0.5}MnO_3$ film (film thickness 80 nm) (FIG. 3(a)) and a $Pr_{0.5}Sr_{0.5}MnO_3$ film (film thickness 40 nm) (FIG. 3(b)) that are used as a metallic state layer and used as a metal-insulator transition layer of the strongly correlated oxide field effect element in an embodiment of the present invention.

FIG. 4 shows graphs of temperature and magnetic field dependence of resistance value of a channel layer of the strongly correlated oxide field effect element in an embodiment of the present invention (t = t1 + t2 = 6 nm, t1 = 3 nm, t2 = 3 nm).

FIG. 5 is a schematic diagram illustrating resistance changes in the channel layer in an embodiment of the present invention.

FIG. 6 is an electronic phase diagram of a bulk single crystal of $Pr_{1-x}Sr_xMnO_3$ (x = 0.4 to 0.6).

FIG. 7 shows a graph of channel layer resistance value against gate voltage in an example of the strongly correlated oxide field effect element in an embodiment of the present invention (t = t1 + t2 = 6 nm, t1 = 3 nm, t2 = 3 nm).

FIG. 8 shows a graph of channel layer resistance value against gate voltage in another example of the strongly correlated oxide field effect element in an embodiment of the present invention (t = t1 + t2 = 5.4 nm, t1 = 2.7 nm, t2 = 2.7 nm).

BEST MODE FOR CARRYING OUT THE INVENTION

An embodiment of the strongly correlated oxide field effect element in accordance with the present invention will be explained below. The components or elements common to all of the drawings are assigned with common reference numerals, unless specifically stated otherwise in the course of explanation. The scale ratio of elements in the embodiments is not necessarily maintained in the drawings.

<First Embodiment>

1. Device Structure

1-1. Configuration Example: Structure of Field Effect Element

An embodiment of a field effect element using a strongly correlated oxide of the present embodiment is explained below with reference to the drawings.

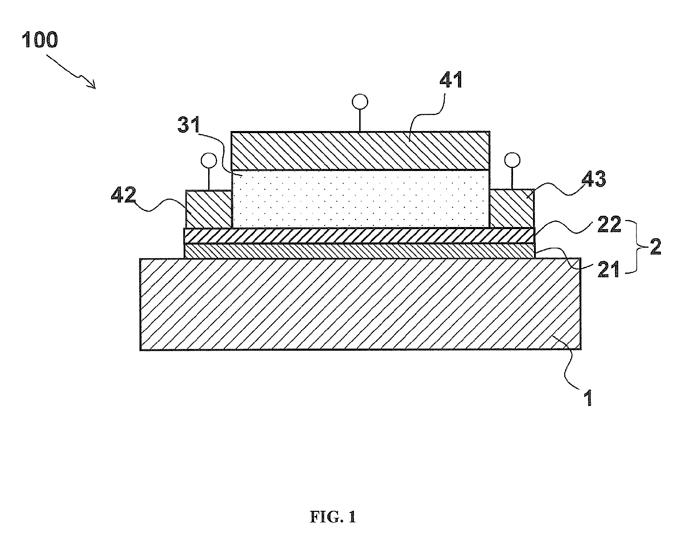

FIG. 1 is a schematic sectional view illustrating the configuration of a strongly correlated oxide field effect element which is an example of the present embodiment. This figure shows the structure of a strongly correlated oxide field effect element 100 (referred to hereinbelow as "field effect element 100") having a top-gate structure. A channel layer 2 including a metallic state layer 21 of a strongly correlated oxide and an insulator-metal transition layer 22 of a strongly correlated oxide in this order from a substrate 1 side is formed on the upper surface of the substrate 1 in FIG. 1. In the entire present application, the term "channel layer" is used merely to facilitate the understanding of the present application by comparison with a MOSFET (Metal Oxide Semiconductor Field Effect Transistor) using, for example, silicon, which is a typical configuration of the conventional field effect element. The mechanism of electric conductivity or resistance control that actually occurs in the element or part representing the channel layer in the present application will be explained separately.

A gate electrode 41 is formed on the upper surface (in FIG. 1) of the channel layer 2, with a gate insulating layer 31 being interposed therebetween. Further, a drain electrode 42 and a source electrode 43 are formed so as to be in contact with the channel layer 2. By selecting perovskite oxides as substances constituting the substrate 1 and the two layers (metallic state layer 21 and insulator-metal transition layer 22) included in the channel layer 2, it is possible to grow the metallic state layer 21 and insulator-metal transition layer 22 of the channel layer 2 epitaxially on the substrate 1. As a result, a high-quality thin film can be fabricated as the channel layer 2. For example, $(LaAlO_3)_{0.3}(SrAl_{0.5}Ta_{0.5}O_3)_{0.7}$ (abbreviated hereinbelow as LSAT) or $SrTiO_3$ is preferred for the substrate 1.

The metallic state layer 21 of a strongly correlated oxide is explained below. When the substrate 1 is made of LSAT, a $Nd_{0.5}Sr_{0.5}MnO_3$ film is preferred as the metallic state layer 21. When the substrate 1 is made of $SrTiO_3$, a $Pr_{0.5}Sr_{0.5}MnO_3$ film is preferred as the metallic state layer 21. However, where a $La_{1-x}Sr_xMnO_3$ (x = 0.2 to 0.4) film is used as the metallic state layer 21, good metallic state layer 21 can be formed in both cases, that is, when the substrate 1 is LSAT and when it is $SrTiO_3$.

The insulator-metal transition layer 22 of a strongly correlated oxide is explained below. When the substrate 1 is made of LSAT, a $Pr_{0.5}Sr_{0.5}MnO_3$ film is preferred as the insulator-metal transition layer 22. When the substrate 1 is made of $SrTiO_3$, a $Nd_{0.5}Sr_{0.5}MnO_3$ film is preferred as the insulator-metal transition layer 22. The gate insulator layer 31, gate electrode 41, drain electrode 42, and source electrode 43 are not required to be perovskite oxides, and appropriately usable substances can be selected therefor.

1-2. Modified Configuration Example: Bottom-Gate Structure

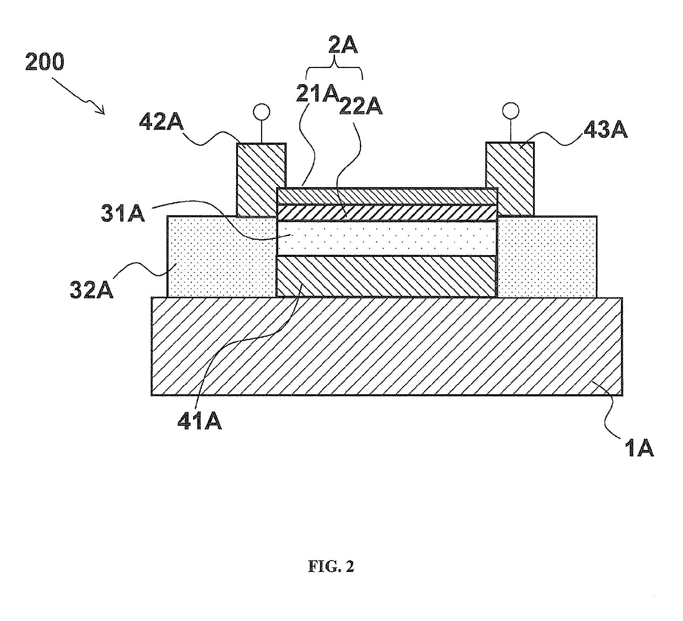

As a modification of the field effect element 100 shown in FIG. 1, in the present embodiment, a strongly correlated oxide field effect element of a bottom-gate structure can be also fabricated. FIG. 2 is a schematic cross-sectional view of a strongly correlated oxide field effect element 200 of a bottom-gate structure (referred to hereinbelow as "field effect element 200"), which is another example of the strongly correlated oxide field effect element of the present embodiment. As shown in FIG. 2, in the field effect element 200, a gate electrode 41A is disposed on a substrate 1A side. In order to fabricate the field effect element 200, first, the gate electrode 41A is formed as a thin conductive oxide film that can be epitaxially grown on the upper surface (in FIG. 2) of the substrate 1A, and then a gate insulating layer 31A, an insulator-metal transition layer 22A of a strongly correlated oxide, and a metallic state layer 21A of a strongly correlated oxide are stacked in this order thereon. Where the substrate 1A, a channel layer 2A (metallic state layer 21A and insulator-metal transition layer 22A), and the gate electrode 41A and gate insulating layer 31A positioned between the channel layer 2A and the substrate 1A are all constituted from perovskite oxides, it is possible to fabricate a high-quality thin film that is epitaxially grown on the substrate 1A as the channel layer 2A. For example, LSAT and $SrTiO_3$ are preferred for the substrate 1A. $La_{1-x}Sr_xMnO_3$ (x = 0.2 to 0.4) is preferably selected for the gate electrode 41A, and a substance same as that of the substrate 1A (that is, LSAT when the substrate 1A is made of LSAT, and $SrTiO_3$ when the substrate 1A is made of $SrTiO_3$) is preferably selected for the gate insulating layer 31A. The insulator-metal transition layer 22A of a strongly correlated oxide is preferably, for example, from a $Pr_{0.5}Sr_{0.5}MnO_3$ film when the substrate 1A is made of LSAT, and from a $Nd_{0.5}Sr_{0.5}MnO_3$ film when the substrate 1A is made of $SrTiO_3$.

When the substrate 1A is LSAT, it is preferred that a $Nd_{0.5}Sr_{0.5}MnO_3$ film be used as the metallic state layer 21A of the strongly correlated oxide in the field effect element 200, and when the substrate 1 is $SrTiO_3$, a $Pr_{0.5}Sr_{0.5}MnO_3$ film is preferred. However, where a $La_{1-x}Sr_xMnO_3$ (x = 0.2 to 0.4) film is used as the metallic state layer 21A, good metallic state layer 21A can be formed with the substrate 1A of either of LSAT and $SrTiO_3$.

In the field effect element 200, first, for example the following four layers are formed: metallic state layer 21A, insulator-metal transition layer 22A, gate electrode 41A, and gate insulating layer 31A. Then, the four layers are etched together by photolithography, and the in-plane shape of the substrate 1A is patterned and processed as shown in FIG. 2. The insulating film 32 is then formed, and then the drain electrode 42 and the source electrode 43 are formed at any position that is in contact with the surface or interface of the channel layer 2. The structure of the field effect element 200 shown in FIG. 2 is thus formed.

2. Fabrication Method Based on Example

A method for fabricating the field effect element of the present embodiment will be described below. The explanation below is based on a specific method in which an example of field effect element 100 of a top-gate structure shown in FIG. 1 is fabricated. The present invention is explained below in greater details with reference to this example. The materials, amounts used, ratios, treatment contents, and treatment procedure in the below-described example can be changed, as appropriate, without departing from the essence of the present invention. Therefore, the scope of the present invention is not limited to the below-described specific example.

The following materials are used in the strongly correlated oxide field effect element of the example: $Pr_{0.5}Sr_{0.5}MnO_3$ for the insulator-metal transition layer 22, $Nd_{0.5}Sr_{0.5}MnO_3$ for the metallic state layer 21, and an LSAT (110) orientation substrate for the substrate 1. None of the components of the production apparatus is shown in the figure.

In the example of the field effect element 100 of the present embodiment, the channel layer 2 constituted by a strongly correlated oxide film was fabricated using a laser ablation method. Polycrystalline materials of respective compositions fabricated by molding into a cylindrical shape with a diameter of 20 mm and a length of 5 mm by a solid-phase reaction method were used as targets for forming films of respective materials. More specifically, a vacuum chamber with an LSAT (110) substrate attached as the substrate 1 was evacuated to a level equal to or lower than $3 \times 10^{-9}$ Torr ($4 \times 10^{-7}$ Pa). High-purity oxygen gas was then introduced at 1 mTorr (0133 Pa), and the substrate was heated till a temperature of 900°C was reached. The targets were then irradiated with a KrF excimer laser beam with a wavelength of 248 nm through a laser beam introducing port of the chamber. A $Nd_{0.5}Sr_{0.5}MnO_3$ film was then formed to a thickness of 11 atomic layers as the metallic state layer 21. A $Pr_{0.5}Sr_{0.5}MnO_3$ film was then formed in the same atmosphere to a thickness of 11 atomic layers as a strongly correlated oxide layer for the insulator-metal transition layer 22. As for the thickness of those atomic layers, the thickness of one atomic layer corresponds to a distance d(110) between the (110) planes. In other words, since the d(110) in $Pr_{0.5}Sr_{0.5}MnO_3$ and $Nd_{0.5}Sr_{0.5}MnO_3$ corresponds to 0.27 nm, a thickness of about 3 nm is obtained for both films constituted by 11 atomic layers. Thus, in the example of the field effect element 100 fabricated herein, the thickness t1 of the strongly correlated oxide insulator-metal transition layer 22 is 3 nm and the thickness t2 of the metallic state layer 21 is 3 nm and therefore the thickness t of the channel layer 2 is 6 nm. The field effect element of another example in which the number of atomic layers was 10 was also fabricated (described hereinbelow).

After the channel layer 2 including the above-described two layers was formed, aluminum oxide was formed as the gate insulating layer 31 by an atomic layer deposition method. A three-terminal field effect element shown in FIG. 1 was then fabricated through photolithography, etching, and electrode fabrication process.

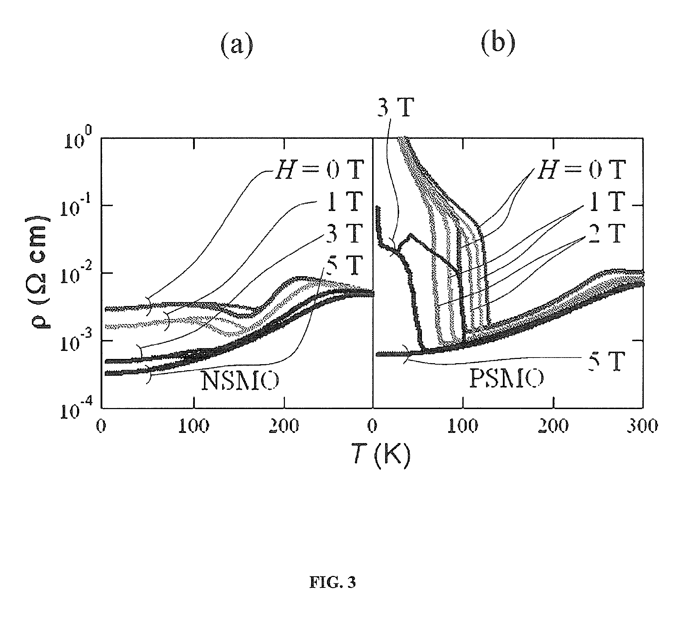

More typical characteristics of the $Nd_{0.5}Sr_{0.5}MnO_3$ used as the metallic state layer 21 and $Pr_{0.5}Sr_{0.5}MnO_3$ used as the insulator-metal transition layer 22 in the above-described example are explained below. FIG. 3 shows graphs of temperature dependence of the volume resistivity p of each material. FIG. 3(a) relates to $Nd_{0.5}Sr_{0.5}MnO_3$ and FIG. 3(b) relates to $Pr_{0.5}Sr_{0.5}MnO_3$. Each graph is plotted by using external magnetic field as a parameter. As shown in FIG. 3(b), the $Pr_{0.5}Sr_{0.5}MnO_3$ film (film thickness 40 nm) demonstrates a sharp metal-insulator transition caused by an orbital order on the LSAT (110) substrate. The results of separate investigation show that the critical film thickness t1c in $Pr_{0.5}Sr_{0.5}MnO_3$ is about 5 nm. By contrast, as shown in the graph in FIG. 3(a), the $Nd_{0.5}Sr_{0.5}MnO_3$ film (film thickness 80 nm) has a metallic phase having a charge- and orbital-ordered insulating phase admixed thereto on the LSAT (110) substrate. The critical film thickness t2c in $Nd_{0.5}Sr_{0.5}MnO_3$ is less than about 5 nm. Therefore, the channel layer 2 in the above-described example satisfies the following condition: $t = t1 + t2 \geq t1c > t2c$, where $t1 < t1c$ and $t2 < t2c$.

As shown in the graph in FIG. 3(a), since the charge- and orbital-ordered insulating phase is admixed to the $Nd_{0.5}Sr_{0.5}MnO_3$ film, the sign of temperature derivative of resistivity in a range of 100 K to 170 K is negative and, strictly speaking, the phase cannot be called a metallic phase. However, in the $Nd_{0.5}Sr_{0.5}MnO_3$ film, the increase in resistance during cooling is small and the sign of temperature derivative of resistivity in other temperature ranges below the Curie temperature $T_C = 200$ K is positive. Therefore, the $Nd_{0.5}Sr_{0.5}MnO_3$ film can be used as the strongly correlated oxide metallic state layer 21 of the present embodiment.

3. Operation Characteristics

3-1. Characteristics of Channel layer

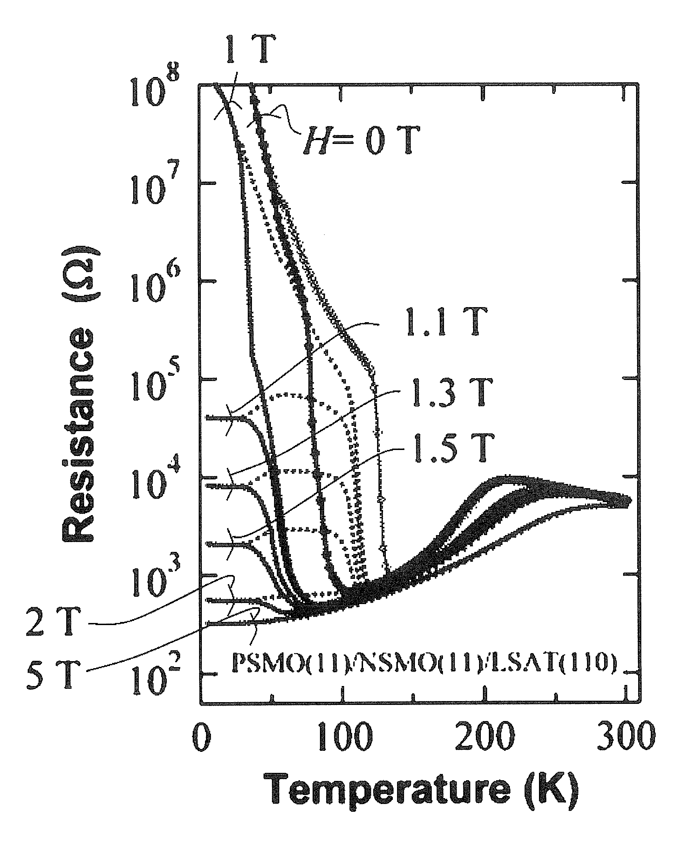

The characteristics of the field effect element 100 will be described below. FIG. 4 is a graph illustrating the electric resistance measured, while changing the temperature and magnetic field, with respect to the channel layer 2 of the field effect element 100 fabricated by the above-described process. As shown in FIG. 4, when the temperature was decreased from room temperature, the electric resistance of the channel layer 2 was confirmed to increase abruptly by six or more orders of magnitude at 100 K. Thus, the entire channel layer 2 constituted by the strongly correlated oxide insulator-metal transition layer 22 and the strongly correlated oxide metallic state layer 21 becomes an insulator due to a metal-insulator transition in the strongly correlated oxide insulator-metal transition layer 22. Thus, although the strongly correlated oxide metallic state layer 21 is present, the metallic phase of the metallic state layer 21 disappears under the effect of the metal-insulator transition in the insulator-metal transition layer 22. Therefore, it was confirmed that colossal resistance changes can be obtained even from the standpoint of the entire channel layer 2.

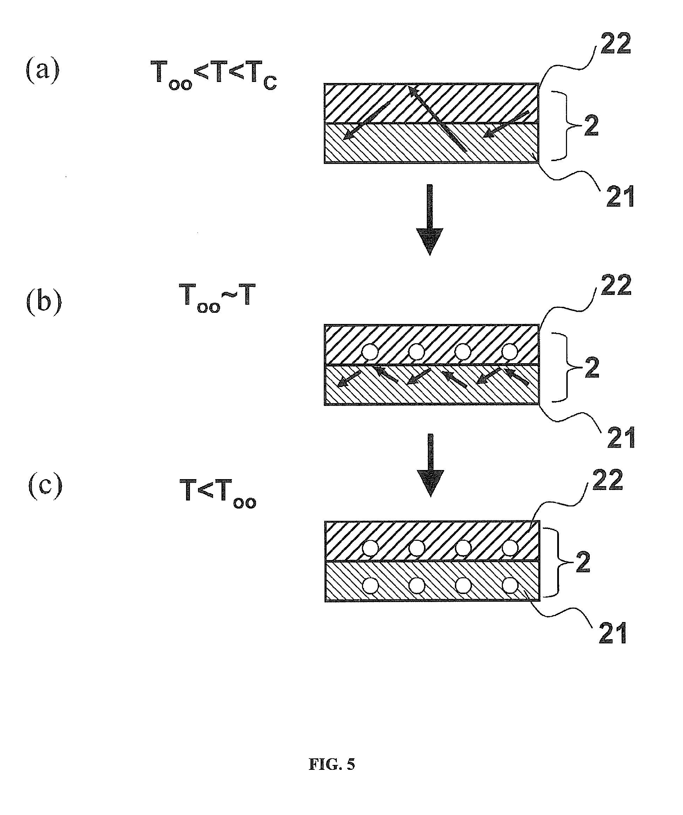

The mechanism allowing such an effect to be observed will be explained below in greater detail by using the model shown in FIG. 5. FIG. 5 is an explanatory drawing illustrating schematically how the conduction carriers move inside the channel layer 2 at a temperature T higher than Too (FIG. 5(a)), about equal to $T_{oo}$ (FIG. 5(b)), and lower than $T_{oo}$ (FIG. 5(c)), where $T_{oo}$ is an orbital ordering temperature. For example, cooling is assumed to be performed from a high-temperature state shown in FIG. 5(a), for example, from room temperature (300 K). In the channel layer 2, in a temperature range close to the Curie temperature $T_C = 200$ K and therebelow, the sign of the temperature derivative of resistivity is positive. In this case, as shown by arrows in FIG. 5(a), the carriers travel through the entire channel layer 2, that is, from the metallic state layer 21 into the insulator-metal transition layer 22 and vice versa. Thus, the sum total thickness t of the channel layer 2 including the abovementioned two layers satisfies the condition $t = t1 + t2 \geq t1c > t2c$. Therefore, the carriers travel through the entire channel layer 2, and an electron state spreading into a three-dimensional region is obtained. As a result, when the strongly correlated oxide insulator-metal transition layer 22 demonstrates a metallic phase, the metallic phase is maintained. It has been previously confirmed that when only a $Pr_{0.5}Sr_{0.5}MnO_3$ film, which is a strongly correlated oxide insulator-metal transition layer, is deposited in 22 atomic layers (thickness about 6 nm), the electron phase of this layer is a metallic phase when the temperature T is reduced close to the Curie temperature $T_C$ = 200 K by cooling.

Where the T is lowered by subsequent cooling to about $T_{oo}$, for example, close to 100 K, a phase transition to the insulating phase is caused by the metal-insulator transition in the insulator-metal transition layer 22 (FIG. 5(b)). In this case, the conduction carriers located inside the metallic state layer 21 disposed in contact with the insulator-metal transition layer 22 "feel" only the thickness t2 of the metallic state layer 21. In other words, the state of conduction carriers is affected by the decrease in the thickness of the region in which the conduction carriers themselves can travel. Thus, the thickness of the conduction carriers is the thickness t2 of the metallic state layer 21, rather than the thickness t of the entire channel layer 2. FIG. 5(b) shows how the conduction carriers travel only in the metallic state layer 21 in such a state. Thus, the conduction carriers in the $Pr_{0.5}Sr_{0.5}MnO_3$ film, which is the insulator-metal transition layer 22, are localized as shown by white circles in the figure, whereas the conduction carriers in the $Nd_{0.5}Sr_{0.5}MnO_3$ film, which is the metallic state layer 21, travel as if the thickness of the channel layer 2 is, for example, reduced by half. Thus, the film thickness that can be "felt" by the conduction carriers in the $Pr_{0.5}Sr_{0.5}MnO_3$ film is switched from the thickness of the entire channel layer 2 to the thickness of only the metallic state layer 21.

Where the temperature is reduced to below $T_{oo}$ by subsequent cooling, the metallic phase of the metallic state layer 21 disappears. As a result, the resistance value of the entire channel layer 2 is increased. FIG. 5(c) illustrates how the conduction carriers are localized in either layer in this state. Thus, where the temperature becomes below $T_{oo}$, the carriers in the $Nd_{0.5}Sr_{0.5}MnO_3$ film, which is the metallic state layer 21, are also localized.

As a result, the resistance of the entire channel layer 2 is governed by the metal-insulator transition of the $Pr_{0.5}Sr_{0.5}MnO_3$ film, which is the insulator-metal transition layer 22. Thus, where the insulator-metal transition layer 22 is a metallic phase, the channel layer is a metallic phase and the resistance thereof decreases, whereas the insulator-metal transition layer 22 is an insulating phase, the channel layer is an insulating phase and the resistance thereof increases.

It was confirmed that where the cooling is performed, while applying a magnetic field, the entire channel layer 2 becomes a metallic phase when the magnetic field application corresponds to a magnetic flux density equal to or greater than 2 T (FIG. 4). This corresponds to a magnetic field threshold (FIG. 3(b)) of the metal-insulator transition in the $Pr_{0.5}Sr_{0.5}MnO_3$ film, which is the insulator-metal transition layer 22. Thus, it was confirmed that the electric resistance of the entire channel layer 2 is also governed by the state of the insulator-metal transition layer 22 when a magnetic field is applied.

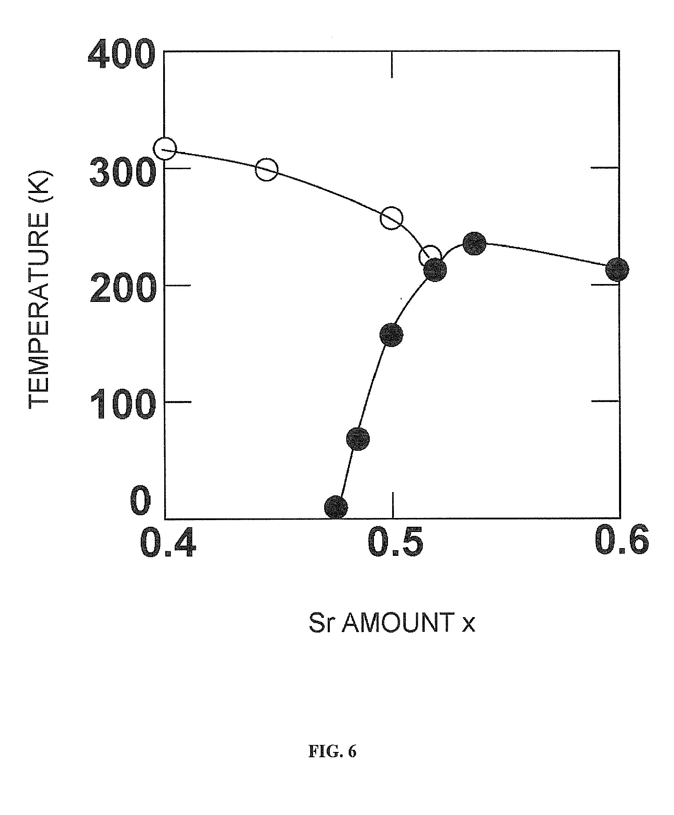

The properties of the $Pr_{1-x}Sr_xMnO_3$ (x = 0.4 to 0.6) bulk single crystal will be explained below with reference to the phase transition of the $Pr_{0.5}Sr_{0.5}MnO_3$ film, which is the insulator-metal transition layer 22. FIG. 6 is an electronic phase diagram of the $Pr_{1-x}Sr_xMnO_3$ (x = 0.4 to 0.6) bulk single crystal. In FIG. 6, the temperature (K) is plotted against the ordinate, and the Sr amount, that is, the hole doping amount x, is plotted against the abscissa. In the figure, white circles represent the transition temperature (Curie temperature) of the ferromagnetic phase, and black circles represent the $T_N$ (Neel temperature) of transition from the ferromagnetic phase to the antiferromagnetic phase. In $Pr_{1-x}Sr_xMnO_3$, since orbital ordering occurs simultaneously with the transition to the antiferromagnetic phase and the carriers are also localized, the metal-insulator transition is also initiated. Therefore, $T_N = T_{oo}$ (orbital ordering temperature) is the temperature at which the metal-insulator transition occurs. As shown in FIG. 6, doping $Pr_{1-x}Sr_xMnO_3$ of the composition with x = 0.5 with electrons corresponds to the movement to the left side in FIG. 6, while maintaining a temperature of, for example, about 100 K. Therefore, doping with electrons results in the appearance of the metallic phase, insulator-to-metal transition, and decrease in temperature. Doping $Pr_{1-x}Sr_xMnO_3$ of the composition with x = 0.5 with holes corresponds to the movement to the right side in the phase diagram. At this side, a layered antiferromagnetic metallic phase appears and therefore the resistance is decreased, but the change in resistance is less than in the case of doping with electrons.

3-2. Resistance Changes Induced by Field Effect

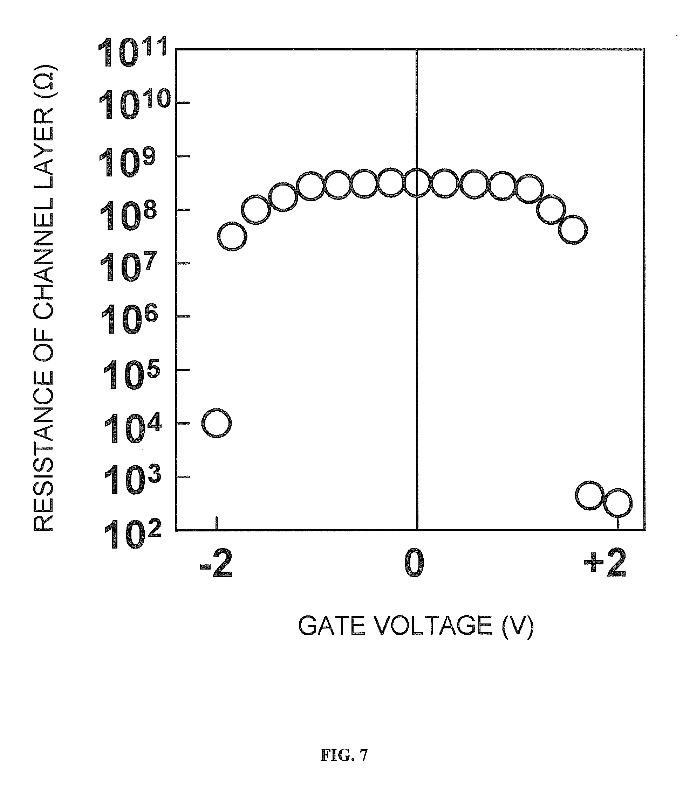

Resistance changes induced by the field effect will be explained below. FIG. 7 is a graph of channel layer resistance against gate voltage in an example of the strongly correlated oxide field effect element 100. White circles in the figure show measured values of electric resistance in the case where voltage is increased from 0 V to 2 V on the positive and negative sides. In this case, the thickness t of the channel layer 2, the thickness t1 of the insulator-metal transition layer 22, and the thickness t2 of the metallic state layer 21 are t = t1 + t2 = 6 nm, t1 = 3 nm, and t2 = 3 nm, respectively. When cooling to 30 K is performed and a voltage of +2 V is applied, resistance changes of five or more orders of magnitude can be obtained. Likewise, when a voltage of -2 V is applied, resistance changes of four or more orders of magnitude is obtained. Thus, the resistance is reduced by gate voltage application, regardless of voltage polarity. This is because the orbital-ordered insulating phase is most stable at a doping amount of 0.5 obtained by Sr replacement in the channel layer, the orbital-ordered insulating phase is unstable when the doping amount is offset to either side, that is, equal to 0.49 or 0.51, and the resistance decreases when the polarity of gate voltage is changed and electrons or holes are doped by the field effect. Further, when the polarity of gate voltage is positive, electrons are doped, and this corresponds to the movement to the left, that is, to the 0.49 side of the doping amount on the electron phase diagram shown in FIG. 6, and when the polarity of gate voltage is negative, holes are doped and this corresponds to the movement to the right, that is, to the 0.51 side of the doping amount on the electron phase diagram shown in FIG. 6. The 0.49 side borders on the metallic phase, whereas the 0.51 side borders on the layered metallic phase, and therefore the decrease in resistance is less than in the case of doping to the 0.49 side, which results in larger resistance changes.

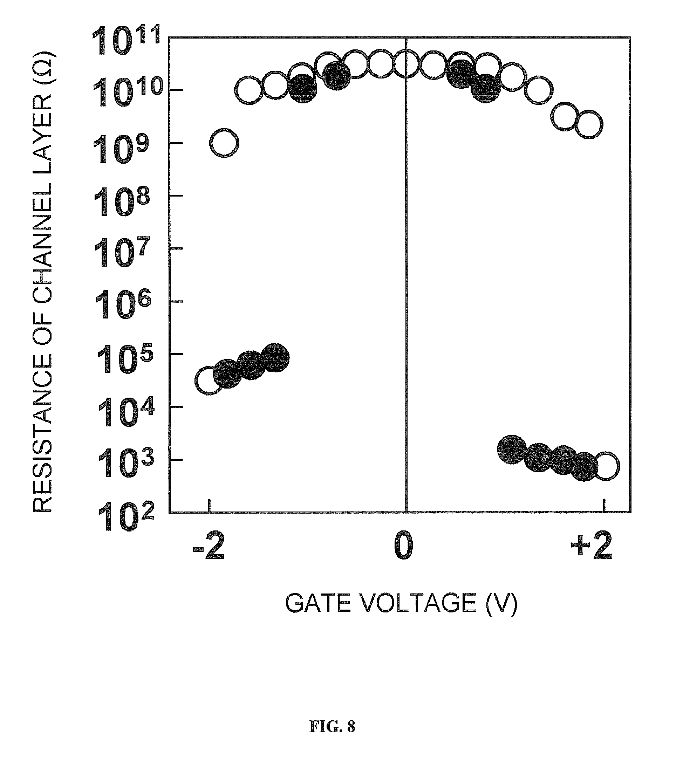

A field effect element of another example that is fabricated by changing the thickness of the above-described channel layer from 11 atomic layers to 10 atomic layers will be explained below. FIG. 8 is a graph of channel layer resistance value against gate voltage in the example of the electric field element 100. The values represented by white holes were measured in the same manner as the values shown in FIG. 7. The thickness t of the channel layer 2, the thickness t1 of the insulator-metal transition layer 22, and the thickness t2 of the metallic state layer 21 are $t = t1 + t2 =$ 5.4 nm, $t1 = 2.7$ nm, and $t2 = 2.7$ nm, respectively. As a result, it was confirmed that when a voltage of +2 V was applied at 30 K in the same manner as in the field effect element of the example shown in FIG. 7, resistance changes of seven or more orders of magnitude were observed. Black circles in the figure represent plots obtained when the voltage was decreased from $\pm 2$ V, that is, when the absolute value of the gate voltage was brought close from 2 V to 0 V at the positive or negative side. It is particularly noteworthy that under positive or negative voltage from 0 V, the values represented by white and black circles shift correspondingly to the phase transition between the metallic phase and insulating phase, and a hysteresis characteristic is observed.

The inventor of the present application draws the following conclusions from the change in electric resistance of the channel layer 2 observed in the field effect element of the above-described examples. In a strongly correlated oxide, in particular, a Mn oxide, a phase transition can be induced by doping a channel layer with a thickness of about 3 nm by using a field effect. It is due to this phase transition that colossal resistance changes or switching effect appear in the channel layer 2.

4. Switching Operation of Strongly Correlated Oxide Field Effect Element

As explained hereinabove, where the channel layer of a strongly correlated oxide field effect element including the channel layer constituted by a strongly correlated oxide film, a gate electrode, a gate insulating layer formed in contact with at least part of a surface or an interface of the channel layer and sandwiched by the channel layer and the gate electrode, and a source electrode and a drain electrode formed in contact with at least part of the channel layer includes an insulator-metal transition layer of a strongly correlated oxide and a metallic state layer of a strongly correlated oxide that are stacked on each other, and the thickness t of the channel layer, the thickness t1 of the insulator-metal transition layer, and the thickness t2 of the metallic state layer satisfy the following relationship $t = t1 + t2 \geq t1c > t2c$, where $t1 < t1c$ and $t2 < t2c$, with critical thicknesses t1c and t2c for metallic phases of the insulator-metal transition layer and the metallic state layer, the resistance value of the entire channel layer can be controlled by the metal-insulator transition of the insulator-metal transition layer. Therefore, the thickness of the channel layer that should be effectively doped can be reduced. In the above-described example, t1 is equal to t2, and therefore the effective channel layer thickness can be reduced by half. As a result, resistance changes up to 7 orders of magnitude are realized. The inventor of the present application thinks that this is because, two-dimensional conduction in a thin region with a thickness t2 is enhanced for conduction carriers and therefore dimensionality for the carriers is decreased and further increase in resistance in a high-resistance state is realized.

The benefit of using a strongly correlated oxide, which has a high resistance among the substances performing metallic electric conductivity, for the metallic state layer 21 is that the critical film thickness t2c becomes comparatively large and the t2 thickness control becomes relatively easy.

On the $SrTiO_3$ (110) substrate, a metal-insulator transition induced by the charge- and orbital -ordered insulating phase $Nd_{0.5}Sr_{0.5}MnO_3$ appears and the critical film thickness t1c is about 5 nm. Meanwhile, $Pr_{0.5}Sr_{0.5}MnO_3$ becomes a metallic phase and the critical film thickness t2c thereof is less than about 5 nm. Therefore, the same effect can be expected when a $Nd_{0.5}Sr_{0.5}MnO_3$ film is used as the strongly correlated oxide insulator-metal transition layer and a $Pr_{0.5}Sr_{0.5}MnO_3$ film is used as the strongly correlated oxide metallic state layer on the $SrTiO_3$ (110) substrate. The difference between the two cases is that the properties of first order transition of the strongly correlated oxide insulator-metal transition layer are different. Since a $Pr_{0.5}Sr_{0.5}MnO_3$ film on an LSAT (110) demonstrates a sharp transition, resistance changes in the channel layer also demonstrate a discrete switching characteristic. Meanwhile, a $Nd_{0.5}Sr_{0.5}MnO_3$ film on a $SrTiO_3$ (110) substrate demonstrates a gentle phase transition and therefore resistance changes in the channel layer also demonstrate an analog linear behavior.

Further, in any case, the switching mechanism explained with reference to FIG. 5 indicates that switching the substantial film thickness that is "felt" by the conduction carriers of the metallic state layer 21 by doping carriers into the insulator-metal transition layer 22 to induce a phase transition of the electron state of the insulator-metal transition layer 22 serves to increase the control range of electric resistance of the channel layer 2. Therefore, in the above-described configuration of the channel layer 2, large changes in the resistance value are realized as long as carrier doping with the gate electrode 41 is effective with respect to the insulator-metal transition layer 22. Effective methods for enhancing this effect include disposing the insulator-metal transition layer 22 closer to the gate insulating layer 31 than the metallic state layer 21 and, more directly, using a configuration in which the insulator-metal transition layer 22 is sandwiched between the metallic state layer 21 and the gate insulating layer 31. The source electrode and drain electrode can operate in contact with either of the metallic state layer 21 and the insulator-metal transition layer 22, and the configuration of the source electrode and drain electrode can be selected such as to conform to the process and element structure such as a top-gate structure or bottom-gate structure.

Further, in the present embodiment, a (110) orientation substrate is used, but since a first order transition is also possible in a single crystal film on a (210) orientation substrate, a strongly correlated oxide field effect element demonstrating colossal resistance changes can be also similarly realized when a (210) orientation substrate is used. The materials of thin films and substrates, compositions thereof, film thicknesses, and formation methods presented by way of examples in the present embodiment are not limited to the above-described embodiment.

The embodiments of the present invention are described in detail hereinabove. The above-described embodiments and examples are described to explain the invention, and the scope of the invention of the present application should be determined on the basis of the appended claims. Further, change examples that exist within the scope of the present invention including other combinations of the embodiments are also included in the scope of patent claims.

INDUSTRIAL APPLICABILITY

The strongly correlated oxide field effect element in accordance with the present invention can be used in a variety of electric and electronic devices using a field effect element demonstrating a switching function induced by electrical means.

EXPLANATION OF REFERENCE NUMERALS

100, 200 strongly correlated oxide field effect elements
1, 1A substrates
2, 2A channel layers
21, 21A metallic state layers
22, 22A insulator-metal transition layers
31, 31A gate insulating layers
32 insulating film
41, 41A gate electrode
42 drain electrode
43 source electrode

**Claims**

1. A strongly correlated oxide field effect element comprising: a channel layer (2) including a strongly correlated oxide film; a gate electrode (41); a gate insulating layer (31) formed in contact with at least part of a surface or an interface of the channel layer and sandwiched by the channel layer and the gate electrode; and a source electrode (43) and a drain electrode (42) formed in contact with at least part of the channel layer,
**characterised in that**
the channel layer includes an insulator-metal transition layer (22) of strongly correlated oxide and a metallic state layer (21) of a strongly correlated oxide that are stacked on each other, and
a thickness t of the channel layer, a thickness t1 of the insulator-metal transition layer, and a thickness t2 of the metallic state layer satisfy the following relationship with critical thicknesses t1c and t2c for metallic states of the insulator-metal transition layer and the metallic state layer:

$$t = t1 + t2 \geq t1c > t2c,$$

where

$$t1 < t1c \text{ and } t2 < t2c.$$

2. The strongly correlated oxide field effect element according to claim 1, wherein the insulator-metal transition layer is sandwiched between the metallic state layer and the gate insulating layer.

3. The strongly correlated oxide field effect element according to claim 1, further comprising a substrate, wherein the channel layer, the gate insulating layer, and the gate electrode are formed on the substrate in this order.

4. The strongly correlated oxide field effect element according to claim 1, further comprising a substrate, wherein the gate electrode, the gate insulating layer, and the channel layer are formed on the substrate in this order.

5. The strongly correlated oxide field effect element according to claim 1 or 2, wherein a resistance between a source and a drain is decreased by voltage application via the gate electrode, regardless of polarity of the voltage.

6. The strongly correlated oxide field effect element according to claim 1 or 2, wherein the insulator-metal transition layer and the metallic state layer are made of a perovskite manganite.

7. The strongly correlated oxide field effect element according to any one of claims 2 to 4, wherein the insulator-metal transition layer and the metallic state layer are made of a perovskite manganite, the substrate is made of $(LaAlO_3)_{0.3}(SrAl_{0.5}Ta_{0.5}O_3)O_{0.7}$, and the insulator-metal transition layer is made of $(Pr, Sr)MnO_3$.

8. The strongly correlated oxide field effect element according to claim 7, wherein the insulator-metal transition layer and the metallic state layer are made of a perovskite manganite, and the substrate has a (110) orientation or a (210) orientation.

9. The strongly correlated oxide field effect element according to any one of claims 2 to 4, wherein the insulator-metal transition layer and the metallic state layer are made of a perovskite manganite, the substrate is made of $SrTiO_3$, and the insulator-metal transition layer is made of $(Nd, Sr)MnO_3$.

10. The strongly correlated oxide field effect element according to claim 9, wherein the insulator-metal transition layer and the metallic state layer are made of a perovskite manganite, and the substrate has a (110) orientation or a (210) orientation.

**Patentansprüche**

1. Feldeffektbauelement mit stark korreliertem Oxid, umfassend: eine Kanalschicht (2), die eine Oxidschicht mit stark korreliertem Oxid aufweist; eine Gateelektrode (41); eine Gateisolierschicht (31), die in Kontakt mit wenigstens einem Teil einer Fläche oder einer Grenzfläche der Kanalschicht gebildet ist und zwischen der Kanalschicht und der Gateelektrode angeordnet ist; und eine Sourceelektrode (43) und eine Drainelektrode (42), die in Kontakt mit wenigstens einem Teil der Kanalschicht gebildet sind, **dadurch gekennzeichnet, dass** die Kanalschicht eine Isolator-Metall-Übergangsschicht (22) aus einem stark korrelierten Oxid und eine Schicht im metallischen Zustand (21) aus einem stark korrelierten Oxid aufweist, die übereinandergestapelt sind, und eine Dicke t der Kanalschicht, eine Dicke t1 der Metall-Isolator-Übergangsschicht und eine Dicke t2 der Schicht im metallischen Zustand die folgende Beziehung mit kritischen Dicken t1c und t2c für den metallischen Zustand der Isolator-Metall-Übergangsschicht und der Schicht im metallischen Zustand erfüllen:

$$t = t1 + t2 \geq t1c > t2c,$$

wobei

$$t1 < t1c \text{ und } t2 < t2c.$$

2. Feldeffektbauelement mit stark korreliertem Oxid nach Anspruch 1, wobei
die Metall-Isolator-Übergangsschicht zwischen der Schicht im metallischen Zustand und der Gateisolierschicht schichtweise angeordnet ist.

3. Feldeffektbauelement mit stark korreliertem Oxid nach Anspruch 1, das ferner ein Substrat umfasst,
wobei die Kanalschicht, die Gateisolierschicht und die Gateelektrode in dieser Reihenfolge auf dem Substrat gebildet sind.

4. Feldeffektbauelement mit stark korreliertem Oxid nach Anspruch 1, das ferner ein Substrat umfasst,
wobei die Gateelektrode, die Gateisolierschicht und die Kanalschicht in dieser Reihenfolge auf dem Substrat gebildet sind.

5. Feldeffektbauelement mit stark korreliertem Oxid nach Anspruch 1 oder 2, wobei
ein Widerstand zwischen einer Source und einem Drain durch Anlegen einer Spannung über die Gateelektrode, unabhängig von der Polarität der Spannung, verringert wird.

6. Feldeffektbauelement mit stark korreliertem Oxid nach Anspruch 1 oder 2, wobei
die Metall-Isolator-Übergangsschicht und die Schicht im metallischen Zustand aus einem Perowskit-Manganit hergestellt sind.

7. Feldeffektbauelement mit stark korreliertem Oxid nach einem der Ansprüche 2 bis 4, wobei
die Metall-Isolator-Übergangsschicht und die Schicht im metallischen Zustand aus einem Perowskit-Manganit hergestellt sind,
das Substrat aus $(LaAlO_3)_{0,3}(SrAl_{0,5}Ta_{0,5}O_3)O_{0,7}$ hergestellt ist, und
die Metall-Isolator-Übergangsschicht aus $(Pr, Sr)MnO_3$ hergestellt ist.

8. Feldeffektbauelement mit stark korreliertem Oxid nach Anspruch 7, wobei
die Metall-Isolator-Übergangsschicht und die Schicht im metallischen Zustand aus einem Perowskit-Manganit hergestellt sind, und
das Substrat eine (110) Orientierung oder eine (210) Orientierung aufweist.

9. Feldeffektbauelement mit stark korreliertem Oxid nach einem der Ansprüche 2 bis 4, wobei
die Metall-Isolator-Übergangsschicht und die Schicht im metallischen Zustand aus einem Perowskit-Manganit hergestellt sind,
das Substrat aus $SrTiO_3$ hergestellt ist, und
die Metall-Isolator-Übergangsschicht aus $(Nd, Sr)MnO_3$ hergestellt ist.

10. Feldeffektbauelement mit stark korreliertem Oxid nach Anspruch 9, wobei
die Metall-Isolator-Übergangsschicht und die Schicht im metallischen Zustand aus einem Perowskit-Manganit hergestellt sind, und
das Substrat eine (110) Orientierung oder eine (210) Orientierung aufweist.

**Revendications**

1. Élément à effet de champ à oxyde fortement corrélé qui comprend : une couche de canal (2) qui comprend un film d'oxyde fortement corrélé ; une électrode de grille (41) ; une couche d'isolation de grille (31) formée en contact avec au moins une partie d'une surface ou d'une interface de la couche de canal, et prise en sandwich par la couche de canal et l'électrode de grille ; et une électrode de source (43) et une électrode de drain (42) formées en contact avec au moins une partie de la couche de canal, **caractérisé en ce que** la couche de canal comprend une couche de transition isolant/métal (22) d'un oxyde fortement corrélé et une couche à l'état métallique (21) d'un oxyde fortement corrélé qui sont empilées l'une sur l'autre, et

une épaisseur t de la couche de canal, une épaisseur t1 de la couche de transition isolant/métal, et une épaisseur t2 de la couche à l'état métallique satisfont la relation suivante avec des épaisseurs critiques t1c et t2c pour les états métalliques de la couche de transition isolant/métal et de la couche à l'état métallique :

$$t = t1 + t2 \geq t1c > t2c,$$

où

$$t1 < t1c \quad \text{et} \quad t2 < t2c.$$

**2.** Élément à effet de champ à oxyde fortement corrélé selon la revendication 1, dans lequel la couche de transition isolant/métal est prise en sandwich entre la couche à l'état métallique et la couche d'isolation de grille.

**3.** Élément à effet de champ à oxyde fortement corrélé selon la revendication 1, qui comprend en outre un substrat, dans lequel la couche de canal, la couche d'isolation de grille, et l'électrode de grille sont formées sur le substrat dans cet ordre.

**4.** Élément à effet de champ à oxyde fortement corrélé selon la revendication 1, qui comprend en outre un substrat, dans lequel l'électrode de grille, la coche d'isolation de grille, et la couche de canal sont formées sur le substrat dans cet ordre.

**5.** Élément à effet de champ à oxyde fortement corrélé selon la revendication 1 ou 2, dans lequel la résistance entre une source et un drain est réduite par l'application d'une tension via l'électrode de grille, quelle que soit la polarité de la tension.

**6.** Élément à effet de champ à oxyde fortement corrélé selon la revendication 1 ou 2, dans lequel la couche de transition isolant/métal et la couche à l'état métallique sont composées d'un manganite de pérovskite.

**7.** Élément à effet de champ à oxyde fortement corrélé selon l'une quelconque des revendications 2 à 4, dans lequel la couche de transition isolant/métal et la couche à l'état métallique sont composées d'un manganite de pérovskite, le substrat est composé de $(LaAlO_3)_{0.3}(SrAl_{0.5}Ta_{0.5}O_3)O_{0.7}$, et la couche de transition isolant/métal est composée de $(Pr, Sr)MnO_3$.

**8.** Élément à effet de champ à oxyde fortement corrélé selon la revendication 7, dans lequel la couche de transition isolant/métal et la couche à l'état métallique sont composées d'un manganite de pérovskite, et le substrat possède une orientation (110) ou une orientation (210).

**9.** Élément à effet de champ à oxyde fortement corrélé selon l'une quelconque des revendications 2 à 4, dans lequel la couche de transition isolant/métal et la couche à l'état métallique sont composées d'un manganite de pérovskite, le substrat est composé de $SrTiO_3$, et la couche de transition isolant/métal est composée de $(Nd, Sr)MnO_3$.

**10.** Élément à effet de champ à oxyde fortement corrélé selon la revendication 9, dans lequel la couche de transition isolant/métal et la couche à l'état métallique sont composées d'un manganite de pérovskite, et le substrat possède une orientation (110) ou une orientation (210).

FIG. 1

**FIG. 2**

FIG. 3

(a) $T_{oo} < T < T_C$

22

2

21

(b) $T_{oo} \sim T$

22

2

21

(c) $T < T_{oo}$

22

2

21

FIG. 5

FIG. 6

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H8133894 B
- JP H10255481 B
- JP H10261291 B
- JP 2005213078 A
- EP 1548843 A1
- US 6890766 B2
- US 6426536 B1

### Non-patent literature cited in the description

- **S. MATHEWS et al.** Ferroelectric Field Effect Transistor Based on Epitaxial Perovskite Heterostructures. *Science,* 1997, vol. 276, 238
- **J. MATSUNO et al.** Magnetic field tuning of interface electronic properties in manganitetitanate junctions. *Applied Physics Letters,* 2008, vol. 92, 122104
- **S. ASANUMA ; TUNING OF THE METAL-INSULATOR TRANSITION IN ELECTROLYTE-GATED NDNIO3 et al.** *Applied Physics Letters,* 2010, vol. 97, 142110